# EUROPÄISCHE PATENTANMELDUNG

(11) **EP 1 148 037 A1**
(43) Veröffentlichungstag der Anmeldung: **24.10.2001**
(21) Anmeldenummer: 00810345.9
(22) Anmeldetag: 19.04.2000
(51) Int. Cl.: C03C 17/34, C23C 14/34

(54) **Herstellungsverfahren für eine Entspiegelungsschicht auf Uhrengläsern**

(71) Anmelder: Blösch Holding AG, 2540 Grenchen (CH)
(72) Erfinder: Wittel, Birgit, 9470 Buchs (CH); Zimmermann, Heinrich, Prof. Dr., 9470 Werdenberg (CH)
(74) Vertreter: AMMANN PATENTANWAELTE AG BERN

(57) **Zusammenfassung**

Eine Entspiegelungsschicht hoher Abrieb- und Kratzfestigkeit kann durch Sputtern auf einem Mineralglas aufgebracht werden, wobei die Substrate näher als üblich zum Target angeordnet werden, um eine erhöhte Dichte der aufgebrachten Schichten zu erhalten. Eine ungleichmässige Abscheidungsgeschwindigkeit kann durch Bewegen des Substrats ausgeglichen werden. Eine gleichmässige Dicke und damit eine hohe optische Güte der Entspiegelungsschicht kann damit auch unter diesen Umständen sichergestellt werden Auf dem bevorzugten Saphir-Uhrenglas sind insbesondere SiO₂ und Si₃N₄, bzw. AlN und Al₂O₃ für die Einzelschichten verwendbar. Diese Schichten weisen keinen spürbaren Farbeffekt auf, bieten aber wegen ihrer hohen Härte eine hohe Abrieb- und Kratzfestigkeit vergleichbar mit Saphirglas.

## Beschreibung

Die vorliegende Erfindung bezieht sich auf ein Verfahren zur Herstellung einer Entspiegelungsschicht gemäss Oberbegriff des Anspruchs 1. Die Erfindung bezieht sich weiterhin auf mit dem Verfahren erhaltene Produkte.

Entspiegelungsschichten (auch Antireflexschichten genannt) sind bekannt und werden weltweit industriell vornehmlich auf Brillengläsern aus Mineralglas oder aus Kunststoffglas und für die Feinoptik auf Linsen jeder Art und Anwendung hergestellt. Solche Entspiegelungen basieren auf Einfachoder Mehrfachschichten und setzen sich aus Kombinationen hoch- und niedrigbrechender Materialien, wie TiO₂, SiO₂, HfO₂, MgF₂ usw. zusammen, welche heute vorzugsweise mittels Aufdampfen, aber auch mittels Aufstäuben (sog. *Sputtern)* aufgebracht werden. Die genannten dielektrischen Materialien zeichnen sich durch ideale Brechwerte aus, wenn sie auf Substrate aufgebracht werden, die ihrerseits Brechwerte n zwischen 1,5 und 2,1 aufweisen. Der einzige Nachteil der aufgedampften Schichten liegt in ihrer relativ geringen Härte, was sich durch schnellen Abrieb und Verkratzen der Oberfläche unangenehm bemerkbar macht, wenn die beschichteten Oberflächen in mechanische Wechselwirkung mit der Umgebung treten (Brillenträger kennen das Problem).

In der Uhrenindustrie werden Entspiegelungsschichten seit den 80-iger Jahren eingesetzt, jedoch zu Beginn ausschliesslich auf Mineralgläsern für professionelle Armbanduhren vom Typ Chronometer. Mit der Einführung von weitgehend kratzfesten Uhrengläsern aus Saphirglas (monokristallines Aluminiumoxid) nimmt die Bedeutung der Entspiegelung zu, weil diese Gläser unbeschichtet insgesamt 6,5 % mehr spiegeln als Mineralgläser. Beim Saphirglas mit seiner hohen optischen Dichte (Brechwert) von 1,77 sind es 7,7 % je Seite, also 15,4 % insgesamt. Die Lesbarkeit des Zifferblattes wird demzufolge um einen Faktor 2 verschlechtert, was vom Markt bemerkt und zunehmend bemängelt wird.

Heute werden Entspiegelungsschichten auf Saphir-Uhrengläsern bei "vorsichtigem" Vorgehen ausschliesslich auf der Glasinnenseite durch Aufdampfen mit dem Resultat aufgebracht, dass die Gesamtreflexion von 15,4 % auf 7,7 % reduziert werden kann und somit in der Grössenordnung eines unbeschichteten Mineralglases (8,4 %) liegt. Die äussere, unbeschichtete Seite weist dabei die hohe Kratzfestigkeit des Saphirglases auf.

Beidseitiges Beschichten wird ebenfalls angewandt. Es wird damit eine optimale Lesbarkeit der Zeitanzeige mit einer Restreflexion von unter 1 % erreicht, was einen deutlichen Unterschied zu nicht beidseitig entspiegelten Uhrengläsern darstellt. Die äussere, durch konventionelle Hochvakuumbedampfung aufgebrachte Entspiegelungsschicht weist jedoch eine deutlich geringere Abriebfestigkeit als das Saphirglas auf. Die Form des Glases hat auf dessen Zerkratzung einen erheblichen Einfluss. So wird ein flaches Glas erheblich weniger verkratzt als ein gewölbtes, da die Angriffsfläche geringer ist. Die Konstruktion der Uhr und das Design sind in der Praxis also auch ausschlaggebend für den Entscheid für oder wider das Anbringen einer doppelseitigen Beschichtung.

Trotzdem besteht der grundsätzliche Nachteil der bekannten Entspiegelungsschichten fort, dass sie gegenüber dem darunterliegenden Material, insbesondere im Fall von Saphirglas, eine deutlich verringerte Abriebfestigkeit aufweisen und leichter verkratzen, wobei zu berücksichtigen ist, dass das Hauptargument für die Verwendung von Saphirglas für Uhren gerade die mechanische Widerstandsfähigkeit ist.

Die bekannten Entspiegelungsschichten zeichnen sich neben anderen Eigenschaften durch hohe optische Qualität *(geringe Restreflexion*, *geringe Dispersion und keine Absorption)* aus. Bei den Schichten mit hoher optischer Qualität wurde dabei die Widerstandsfähigkeit als zweitrangig eingestuft und daher sind solche Schichten nur mit geringer mechanischer Widerstandsfähigkeit bekannt.

Die Hauptaufgabe der Erfindung besteht daher darin, ein Verfahren anzugeben, mit dem auf einem Mineralglassubstrat eine Entspiegelungsschicht mit einer hohen Kratzfestigkeit herstellbar ist, die derjenigen des Substrats, insbesondere von Saphirglas, annähernd entspricht, und die eine hohe optische Güte (insbesondere geringe Restreflexion)aufweist.

Ein derartiges Verfahren ist im Anspruch 1 angegeben. Die weiteren Ansprüche geben bevorzugte Ausführungen und mit dem Verfahren erhaltene Produkte an. Die bevorzugte Anwendung des Verfahrens ist dabei die Herstellung von Antireflexschichten auf Saphirgläsern, da es mit dem erfindungsgemässen Verfahren erstmals ermöglicht wird, eine Antireflexschicht auf Saphirglas aufzubringen, ohne dessen Kratzfestigkeit merklich zu beeinträchtigen.

Als Mineralglas wird dabei allgemein optisch transparentes, anorganisches Material verstanden.

Demgemäss wird eine solche Schicht im wesentlichen durch Sputtern hergestellt. Die Sputtertechnik (PEPVD) wird in der Dünnschichttechnik für die Optik der Uhrenindustrie noch nicht eingesetzt, da die Schichtdickenkontrolle schwieriger als bei der konventionellen Bedampfungstechnik ist. Es wurde jedoch gefunden, dass sich die Härte und Dichte der aufgebrachten Schichten erhöhen lässt, wenn die zu beschichtenden Gegenstände näher an das Target herangerückt werden und geeignete Beschichtungsmaterialien verwendet werden.

Die Erfindung soll weiter an einem Ausführungsbeispiel unter Bezugnahme auf die Figuren erläutert werden.
- **Fig. 1**: **zeigt schematisch eine Sputteranlage; und**
- **Fig. 2**: **zeigt schematisch die Bestimmung des Durchmessers bei nichtkreisförmigen Targets.**

### Schichtmaterial

Es hat sich gezeigt, dass für eine hohe Kratzfestigkeit die Schichten aus Material möglichst hoher Härte bestehen müssen. Eine Kombination, die diese Forderung erfüllt, ist SiO₂/Si₃N₄ (Siliziumdioxid/Siliziumnitrid). Diese Kombination weist allerdings einen geringeren Brechungsindexunterschied (SiO₂:1,46; Si₃N₄:2,0) gegenüber den üblichen Paarungen (***z.B. TiO***_{***2***}***: 2.35, SiO***_{***2***}***: 1.46)*** auf, erfordert also dickere Schichten und die Restreflexion ist grösser.

Überraschenderweise konnten auch diese dickeren Schichten durch Sputtern in der nötigen Qualität hergestellt werden. Dabei weist diese Kombination noch den Vorteil auf, dass nur ein Sputtertarget benötigt wird und die Art der Schicht allein durch Wechsel des Reaktionsgases eingestellt werden kann. Die Schichtenfolgen und -dicken, die für eine Entspiegelung nötig sind, werden nach den üblichen Regeln der Dünnschichtoptik bestimmt. Bevorzugt werden mindestens 2 Schichten aus einem hoch- und einem niedrigbrechenden Material mit der niedrigbrechenden Schicht als letzte Schicht aufgebracht. Eine weiter verbesserte Wirkung über den betrachteten Spektralbereich ergeben z. B. 4 Schichten, also beginnend mit dem Substrat: Si₃N₄/SiO₂/Si₃N₄/SiO₂)
Mit diesen Schichtmaterialien wurde auch eine gegenüber herkömmlichen Schichten verbesserte chemische Beständigkeit erreicht. Die Schicht kann jedoch immer noch ohne Beschädigung des Substrats durch Einwirken chemischer Mittel entfernt werden.

Eine weitere Erhöhung der Widerstandsfähigkeit kann durch Aufbringen einer zusätzlichen, dünnen Schutzschicht bewirkt werden. Die Schutzschicht ist wesentlich dünner als jede der Schichten der Antireflexschicht und bevorzugt höchstens halb so dick wie die dünnste dieser Schichten.

Eine andere denkbare Schichtkombination von hoher Härte ist die Paarung AlN/Al₂O₃ mit Brechwerten von 2,38 bzw. 1,67. Die Restreflexion ist zwar höher als bei üblichen Paarungen, jedoch ist die Härte der obersten Schicht optimal.

### Schichtherstellung

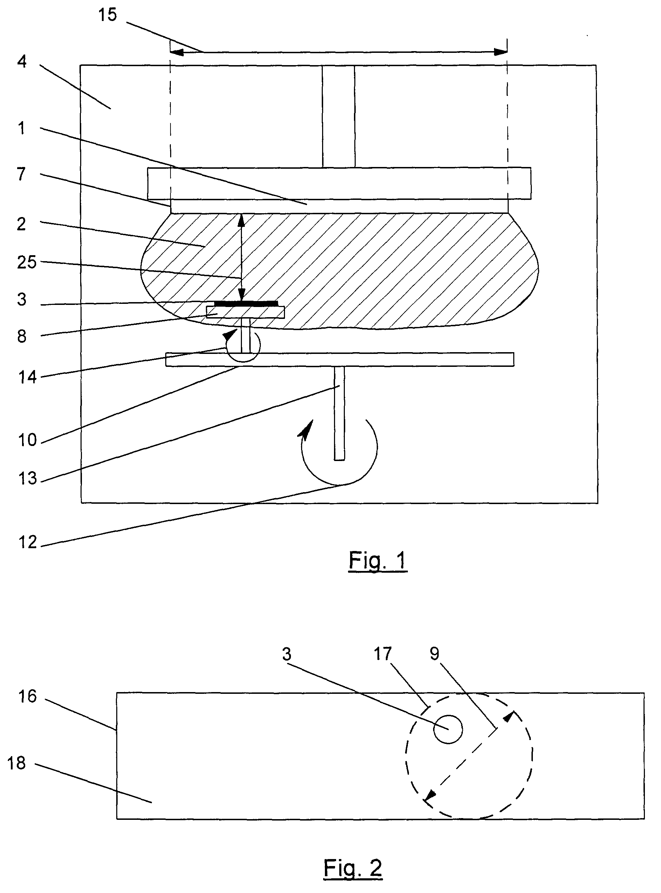

Figur 1 zeigt schematisch eine Sputtereinrichtung 4. Ein Substrat 3, z. B. aus Saphirglas, wird in relativ grosser Nähe zum Target 1 angeordnet. Dieser Bereich des Plasmas 2 wurde bisher für die Beschichtung als nicht verwendbar angesehen, da hier zum einen eine hohe thermische Belastung der Objekte auftritt und die Beschichtung noch sehr ungleichmässig ausfällt, da die Dichte des Plasmas mit dem Ort sehr stark variiert. Es tritt also der Effekt auf, dass nahe dem Zentrum des Targets 1 befindliche Bereiche des Substrats 3 ein hohes Schichtwachstum aufweisen, entferntere oder näher zum Rand 7 des Targets 1 befindliche Bereiche dagegen ein deutlich geringeres.

Es wurde gefunden, dass Saphirglas, aber auch andere Mineralgläser, in der Lage sind, dieser thermischen Beanspruchung zu widerstehen und es somit möglich ist, mit der Sputtertechnik sehr dichte und damit harte Schichten herzustellen. Bei dem erfindungsgemässen Sputterprozess erreichen die Substrate Temperaturen von 300 °C bis 400 °C, freistehende Substrate auch bis 600 °C. Für eine gleichmässige Schichtdicke, die eine Voraussetzung für eine hohe optische Qualität ist, kann das Objekt über dem Target bewegt und somit das Schichtwachstum ausgemittelt werden.

Hierzu werden die Substrate 3 auf Trägern 8 angeordnet, die drehbar auf einem Teller 10 angebracht sind. Während der Beschichtung dreht sich der Teller 10 gemäss Pfeil 12 um die Achse 13, und gleichzeitig drehen sich auch die Träger 8 und damit die Substrate 3 gemäss Pfeil 14. Die Drehbewegung der Träger 8 kann durch einen eigenen Antrieb erfolgen, aber auch z. B. durch ein Getriebe aus der Drehung des Tellers 10 abgeleitet werden. Derartige Antriebe und Getriebe sind an sich bekannt. Vorteilhafterweise wird eine möglichst grosse Zahl Träger 8 auf dem Teller 10 angeordnet, so dass eine grosse Anzahl Substrate gleichzeitig beschichtet werden kann.

Für eine Verbesserung der Haftung der Schichten auf dem Substrat wurden die Substrate vor dem Beginn des Sputterprozesses vorgeheizt. Vermutlich beruht die vorteilhafte Wirkung des Vorheizens bei dem erfindungsgemässen Verfahren darauf, dass die Temperaturdifferenz zwischen Plasma und Substrat insbesondere zu Beginn des Sputterns verringert wird.

Als ein Richtmass für die Entfernung des Substrates 3 vom Target 1 kann das Verhältnis des Abstandes Substrat-Target d_{ST} 25 zum Durchmesser des (kreisförmigen) Targets q 15 dienen: d_{ST}/q = 1 ist bereits eine relative grosse Entfernung, bevorzugt sind Werte um 1/2, besser 1/3 oder kleiner. Bei einer Anordnung an einem anderen Ort als über dem Zentrum des Targets ist gegebenenfalls der Abstand geringer zu wählen, so dass sich das Substrat noch in einem Bereich gleicher oder eventuell höherer Plasmadichte befindet, als wenn es gemäss dieser Regel über dem Zentrum angeordnet wäre.

Bei nicht kreisförmigen Targets wie dem rechteckigen Target 16 in Figur 2 kann der Durchmesser q 15 so bestimmt werden, dass der Durchmesser einer grösstmöglichen, auf das Target 16 auflegbaren Scheibe genommen wird. Mit anderen Worten wird der Durchmesser des Inkreises 17 auf der Targetoberfläche 18 genommen. Inkreis 17 oder äquivalent Scheibe sind dabei unter dem Substrat 3 anzuordnen.

Die Sputtertechnik bietet damit trotz dem dem hohen Anlagenpreis grosse Vorteile bezüglich Schichteigenschaften wie Härte und Abriebfestigkeit. Im Vergleich zu konventionell aufgedampften Schichten sind die gesputterten Schichten viel dichter und härter.

Die Härte der Schichten ist jedoch praktisch nicht bestimmbar, da die gängigen Messverfahren u. a. wegen der geringen Dicke der Schichten im wesentlichen entweder die Härte des Substrates bestimmen oder Artefakte liefern. Die mechanische Widerstandsfähigkeit wurde daher als Abrieb- und Kratzfestigkeit in einem "verschärften Bayer-Test" gemessen, da der genormte Bayer-Test die Schichten nicht merklich angreift.

Bei dem Bayer-Abrasionstest gemäss ASTM F735-81 befinden sich Testsubstrate, z. B. Kunststoffgläser, auf dem Boden einer Blechwanne. Sie werden mit einer bestimmten Menge Quarzsand bedeckt. Die Wanne wird mit Hilfe einer Schüttelvorrichtung 100 bis 600 Zyklen Schüttelbewegungen ("strokes") mit einer vorgegebenen Frequenz und Amplitude unterworfen. Die Zunahme des Streulichts gegenüber dem unbeschichteten Substrat ergibt ein Mass für die Kratzbeständigkeit.

### Beispiel 1:

Je eine Linse aus Saphirglas und aus Mineralglas wird in einem Abstand von 60 mm zum Target mit Durchmesser 125 mm gebracht und bei einem Prozessdruck von p = 5·10⁻³ mBar abwechslungsweise mit Siliziumnitrid und -oxid durch reaktives Sputtern von Silizium mit Sauerstoff bzw. Stickstoff mit einer Antireflexschicht beschichtet, wobei die ersten beiden Schichten physikalische Dicken von 20 nm, die beiden letzten physikalische Dicken von 90 bzw. 120 nm aufweisen. Die Abriebfestigkeit wird mit dem genannten Bayer-Test gemäss ASTM F 735.94 gemessen, dessen Testbedingungen wie folgt verschärft wurden:
- Korund-Sand statt Quarz-Sand,
- 13500 "strokes" statt 600,
- 60 mm Hub statt 50 mm, und
- Höhe der Sandschicht 25 mm statt 13 mm.
- Frequenz 450 min⁻¹ statt 300 min⁻¹.

Zum Vergleich wurde jeweils auch ein unbeschichtetes Substrat und ein Substrat mit einer konventionellen aufgedampften Beschichtung gemessen.

Folgendes Ergebnis wurde erhalten:

**Tabelle 1:**

| Streulicht-Zunahme des transparenten Substrates nach dem verschärften Bayertest | |
|---|---|
| Substrat | Streulichtwert |
| Saphir | 0.1 % |
| Saphir + Schicht gesputtert gemäss Erfindung | 0.2 % |
| Saphir + konventionelle Schicht(aufgedampft) | Schicht vollständig entfernt |
| Mineralglas | 0.7 % |
| Mineralglas + gesputterte Schicht gemäss Erfindung | 0.4 % |

### Beispiel 2:

Eine Saphirglaslinse wird in einem Abstand von 75 mm zum Target mit Durchmesser 125 mm gebracht und bei einem Prozessdruck von p = 5·10⁻³ mBar abwechslungsweise mit Siliziumnitrid und -oxid durch reaktives Sputtern von Silizium mit Sauerstoff bzw. Stickstoff mit einer Antireflexschicht beschichtet, wobei die ersten beiden Schichten physikalische Dicken von 20 nm, die beiden letzten physikalische Dicken von 90 bzw. 120 nm aufweisen. Die Abriebfestigkeit wird mit dem verschärften Bayertest gemessen (siehe Beispiel 1). Folgendes Ergebnis wurde erhalten:

**Tabelle 2:**

| Streulicht-Zunahme des transparenten Substrates nach dem verschärften Bayertest | |
|---|---|
| Substrat | Streulichtwert |
| Saphir | 0.1 % |
| Saphir + Schicht gesputtert gemäss Erfindung | 0.4 % |

### Beispiel 3

Eine Saphirlinse wird in einem Abstand von **80 mm** zum Target mit Durchmesser 125 mm gebracht und bei einem Prozessdruck von p = 5·10⁻³ mBar abwechslungsweise mit Siliziumnitrid und -oxid durch reaktives Sputtern von Silizium mit Sauerstoff bzw. Stickstoff mit einer Antireflexschicht beschichtet, wobei die ersten beiden Schichten optische Dicken von 20 nm, die beiden letzten optische Dicken von 90 bzw. 120 nm aufweisen. Die Abriebfestigkeit wird mit dem verschärften Bayer-Test gemessen (siehe Beispiel 1). Folgendes Ergebnis wurde erhalten:

**Tabelle 3:**

| Streulicht-Zunahme des transparenten Substrates nach dem verschärften Bayertest | |
|---|---|
| Substrat | Streulichtwert |
| Saphir | 0.1 % |
| Saphir + Schicht gesputtert gemäss Erfindung | Schicht vollständig entfernt |

Die gemäss Beispiel 1 erhaltenen Beschichtungen können als weitgehend kratzfest betrachtet werden. Der gegenüber reinem Saphirglas erhöhte Streulichtwert (um 0,1 % bzw. auf das Doppelte) ist mit blossem Auge nicht feststellbar. Dagegen ist die Streulichtzunahme der Linse gemäss Beispiel 2 bereits bemerkbar. Das Ergebnis des Beispiels 3 spricht für sich. Es ist allerdings zu bemerken, dass der angewandte verschärfte Bayer-Test wesentlich höhere Anforderungen an die Testobjekte stellt, als sie in der Praxis auftreten. Je nach Anforderungen kann daher auch eine Beschichtung gemäss Beispiel 3 noch genügen. Auf der anderen Seite ist mit einem noch geringeren Abstand eine weiter erhöhte Kratzfestigkeit erzielbar.

Auf Mineralglas bewirkt die erfindungsgemässe Schicht sogar eine Verbesserung der Kratzfestigkeit gegenüber dem unbehandelten Substrat (Beispiel 1).

### Beispiel 4

Als weiteres praktisches Beispiel wurde eine Lupe aus Saphirglas, wie sie auf Uhrengläsern verwendet wird, beschichtet. Die Lupe von 7 mm Durchmesser weist eine relativ grosse Krümmung auf, welche beim Beschichten zu berücksichtigen ist, da eine Schichtdickenänderung von 2% bereits optisch sichtbar ist.

Die hohe Krümmung führt, wie eingangs erwähnt, auch zu einer erhöhten Anfälligkeit für mechanische Abnutzung.

Die Begutachtung der beschichteten Lupe ergab trotz der hohen Krümmung eine hohe optische Qualität ohne merkliche Verschlechterung gegenüber den weniger problematischen Linsen der Beispiele 1 bis 3.

Aus der Darstellung des erfindungsgemässen Verfahrens und der damit herstellbaren Schichten sind dem Fachmann Modifikationen und Anpassungen zugänglich, ohne den Schutzbereich der Ansprüche zu verlassen. Denkbar sind z. B. folgende:
- Verwendung von anderen Mineralgläsern als Saphirglas als Substrat;
- Sputtern anderer Schichten auf ein Mineralglas zum Erzielen einer Entspiegelung hoher Härte, wobei die für Abrieb- und Kratzfestigkeit nötigen Eigenschaften durch die Prozessparameter des Sputterns und die Wahl der Schichtzusammendsetzungen eingestellt werden;
- Wahl anderer Schichtpaare hoher Härte des Grundmaterials, insbesondere auch mit nicht gleichmässiger Absorption im sichtbaren Spektrum, um Farbeffekte zu erzielen, z. B. ZrN/ZrO₂;
- Aufbau der Antireflexschicht aus einer anderen Anzahl Schichten gleich oder grösser als zwei, auch mit ungerader Schichtzahl, z. B. mit 5 Schichten;
- Aufbringen von Schichten mit anderer Paarung und/oder aus mehreren Paarungen, z. B. zwei Schichten aus SiO₂/AlN oder eine Schichtfolge SiO₂/Si₃N₄/Al₂O₃/AlN, auch mit einer anderen Folge unterschiedlicher Paarungen.

### Glossar

- PEPVD: plasma-enhanced physical vapor deposition
- PVD: physical vapor deposition

## Patentansprüche

1. Verfahren zur Herstellung einer Entspiegelungsschicht auf einem Substrat aus einem optisch transparenten, anorganischen Material, **dadurch gekennzeichnet, dass** wechselweise Schichten verschiedenen Brechungsindexes mittels eines plasmaunterstützten PVD-Verfahrens, insbesondere durch "Sputtern", auf das Substrat aufgebracht werden, wobei der Abstand zwischen Target und Substrat so gewählt wird, dass die erhaltenen Schichten eine Kratzfestigkeit ähnlich oder höher als das Substrat aufweisen.

2. Verfahren gemäss Anspruch 1, **dadurch gekennzeichnet, dass** als Substrat Mineralglas oder Saphirglas verwendet wird.

3. Verfahren gemäss einem der Ansprüche 1 bis 2, **dadurch gekennzeichnet, dass** die Schichten aus mindestens zweien der der folgenden Materialien hergestellt werden: SiO₂, Si₃N₄, Al₂O₃, AlN, ZrN, ZrO₂, wobei SiO₂ und Si₃N₄ bevorzugt sind.

4. Verfahren gemäss einem der Ansprüche 1 bis 3, **dadurch gekennzeichnet, dass** die Schichten aus mindestens einer der folgenden Paarungen bestehen: SiO₂ und Si₃N₄, Al₂O₃ und AlN, ZrN und ZrO₂, wobei die Paarung SiO₂/Si₃N₄ bevorzugt ist.

5. Verfahren gemäss einem der Ansprüche 1 bis 4, **dadurch gekennzeichnet, dass** das Verhältnis zwischen dem Abstand d_{ST} (25) des Substrats vom Target mit Durchmesser q (15) höchstens 1 beträgt, wenn das Substrat in etwa gegenüber dem Zentrum des Targets angeordnet ist, wobei der Durchmesser q bei anderen als kreisförmigen Targets durch den grösstmöglichen, auf die Oberfläche des Targets unter dem Substrat aufzeichenbaren Kreis bestimmt ist, und bei anderer Anordnung des Substrats der Abstand d_{ST} so gewählt ist, dass die Plasmadichte am Ort des Substrats gleich oder grösser als bei genannter zentraler Positionierung ist.

6. Verfahren gemäss einem der Ansprüche 1 bis 5, **dadurch gekennzeichnet, dass** das Verhältnis d_{ST} zu q höchstens 1/2, bevorzugt höchstens 1/3 ist.

7. Verfahren gemäss einem der Ansprüche 2 bis 6, **dadurch gekennzeichnet, dass** die Substrate vor dem Beschichten vorgeheizt werden, um die Haftung der Schichten zu verbessern

8. Verfahren gemäss einem der Ansprüche 2 bis 7, **dadurch gekennzeichnet, dass** im "verschärften Bayer-Test" der Streulichtwert der erhaltenen Entspiegelungsschicht maximal doppelt so hoch ist wie das unbeschichtete Saphirglas.

9. Verfahren gemäss einem der Ansprüche 1 bis 8, **dadurch gekennzeichnet, dass** als letzte Schicht eine Schutzschicht aufgebracht wird, um die chemische Beständigkeit zu erhöhen, wobei die Schutzschicht deutlich dünner als und bevorzugt maximal halb so dick wie die dünnste der Schichten der Antireflexschicht ist.

10. Verfahren gemäss Anspruch 9, **dadurch gekennzeichnet, dass** die Schutzschicht aus einem der folgenden Materialien besteht: Si₃N₄, ZrN, Al₂O₃, ZrO₂.

11. Uhrenglas aus Mineralglas, bevorzugt Saphirglas, **dadurch gekennzeichnet, dass** mindestens ein Teil der Oberfläche, bevorzugt eine Lupe, oder die gesamte Oberfläche mit einer Entspiegelungsschicht versehen ist, die nach dem Verfahren gemäss einem der Ansprüche 1 bis 10 herstellbar ist.

12. Uhrenglas gemäss Anspruch 11, **dadurch gekennzeichnet, dass** die Entspiegelungsschicht eine Kratzfestigkeit im wesentlichen gleich zum oder höher als das Material des Uhrenglases aufweist und im Fall einer mehrschichtigen Entspiegelungsschicht die einzelnen Schichten für sich diese Eigenschaft aufweisen.

13. Uhrenglas gemäss einem der Ansprüche 11 bis 12, **dadurch gekennzeichnet, dass** die Entspiegelungsschicht im wesentlichen farbneutral ist.

14. Uhr mit einem Uhrenglas gemäss einem der Ansprüche 11 bis 13.
